# EUROPÄISCHE PATENTSCHRIFT

(11) **EP 2 761 673 B1**
(45) Veröffentlichungstag und Bekanntmachung des Hinweises auf die Patenterteilung: **22.01.2020**
(21) Anmeldenummer: 12778258.9
(22) Anmeldetag: 28.09.2012
(51) Int. Cl.: H02S 40/34

(54) **SOLARMODUL MIT ANSCHLUSSDOSE, SOWIE VERFAHREN ZUM HERSTELLEN DESSELBEN**
SOLAR MODULE WITH CONNECTION BOX AND METHOD FOR PRODUCTION OF SAME
MODULE SOLAIRE DOTÉ D'UNE BOÎTE DE RACCORDEMENT AINSI QUE SON PROCÉDÉ DE FABRICATION

(30) Priorität: 30.09.2011 EP 11183515
(43) Veröffentlichungstag der Anmeldung: 06.08.2014
(73) Patentinhaber: (CNBM) Bengbu Design & Research Institute for Glass Industry Co., Ltd., Bengbu (CN)
(72) Erfinder: DÖCH, Matthias, 81377 München (DE); KUSTER, Hans-Werner, 52066 Aachen (DE)
(74) Vertreter: Gebauer, Dieter Edmund
(86) Internationale Anmeldenummer: PCT/EP2012/069294
(87) Internationale Veröffentlichungsnummer: WO 2013/045682

(56) Entgegenhaltungen:
- WO-A2-2009/129405
- DE-B3- 10 334 935
- US-A- 5 503 684

## Beschreibung

Photovoltaische Schichtensysteme zur direkten Umwandlung von Sonnenlicht in elektrische Energie sind hinlänglich bekannt. Gemeinhin werden diese als "Solarzellen" bezeichnet, wobei sich der Begriff "Dünnschichtsolarzellen" auf Schichtensysteme mit geringen Dicken von nur wenigen Mikrometern bezieht, die ein Trägersubstrat für eine ausreichende mechanische Festigkeit benötigen. Bekannte Trägersubstrate umfassen anorganisches Glas, Kunststoffe (Polymere) oder Metalle, insbesondere Metalllegierungen, und können in Abhängigkeit von der jeweiligen Schichtdicke und den spezifischen Materialeigenschaften als starre Platten oder biegsame Folien ausgestaltet sein.

Hinsichtlich der technologischen Handhabbarkeit und des Wirkungsgrads haben sich Dünnschichtsolarzellen mit einer Halbleiterschicht aus amorphem, mikromorphem oder polykristallinem Silizium, Cadmium-Tellurid (CdTe), Gallium-Arsenid (GaAs) oder einer Chalkopyrit-Verbindung, insbesondere Kupfer-Indium/Gallium-Dischwefel/Diselenid, abgekürzt durch die Formel Cu(In,Ga)(S,Se)₂, als vorteilhaft erwiesen. Insbesondere Kupfer-Indium-Diselenid (CuInSe₂ bzw. CIS) zeichnet sich aufgrund seines an das Spektrum des Sonnenlichts angepassten Bandabstands durch einen besonders hohen Absorptionskoeffizienten aus.

Mit einzelnen Solarzellen können typischer Weise nur Spannungspegel von weniger als 1 Volt erreicht werden. Um eine technisch brauchbare Ausgangsspannung zu erhalten, werden eine Vielzahl Solarzellen in einem Solarmodul seriell miteinander verschaltet. Hierbei bieten Dünnschichtsolarmodule den besonderen Vorteil, dass die Solarzellen schon während der Schichtenherstellung in integrierter Form verschaltet werden können. In der Patentliteratur wurden Dünnschichtsolarmodule bereits vielfach beschrieben. Lediglich beispielhaft sei auf die Druckschriften DE 4324318 C1 und EP 2200097 A1 verwiesen.

Typischer Weise werden die Schichten zur Herstellung der Dünnschichtsolarzellen direkt auf ein Substrat aufgebracht, das mit einem weiteren Substrat zu einem bewitterungsstabilen Verbund verklebt wird. Der Schichtenaufbau zwischen den beiden Substraten umfasst eine Rückelektrodenschicht und eine photovoltaisch aktive Absorberschicht. Die Absorberschicht verfügt über eine Halbleiterschicht und eine Frontelektrodenschicht. Für einen elektrischen Außenanschluss weist jedes Dünnschichtsolarmodul zwei Spannungsanschlüsse auf. Hierfür sind beispielsweise zwei die Rückelektrodenschicht kontaktierende Sammelleiter vorgesehen, die jeweils mit einem zur Modulrückseite geführten Folien- bzw. Flachbandleiter elektrisch leitend verbunden sind. Auf der Modulrückseite sind die beiden Folienleiter an ein oder mehrere Anschlussdosen angeschlossen, die mit einem Anschlusskabel oder einer Steckverbindung versehen sind. Eine solche Anschlussdose ist beispielsweise aus der DE 102005025632 A1 bekannt. An den Anschlussdosen kann das Solarmodul mit weiteren Solarmodulen zu einem Modulstrang in Reihe verschaltet oder mit einer elektrischen Last verbunden werden, bei welcher es sich häufig um einen Wechselrichter zum Umrichten der erzeugten Gleichspannung in eine für das öffentliche Stromnetz geeignete Wechselspannung handelt.

In der industriellen Serienfertigung werden die Folienleiter manuell an die Anschlussdosen angeschlossen, wofür beispielsweise Klemmkontakte vorgesehen sind. Eine einfache und kostengünstige Automatisierung ist nicht möglich, so dass die Herstellung der Solarmodule mit relativ hohen Fertigungskosten verbunden ist.

Weiterhin kann man bei Dünnschichtsolarmodulen eine kontinuierliche Zunahme des Serienwiderstands beobachten, der nach Standzeiten von mehreren Tausend Betriebsstunden allmählich in einen zumindest annähernd konstanten Wert übergeht. Diese Alterung führt zu einer unerwünschten Verschlechterung des Wirkungsgrads des Solarmoduls. Es wird angenommen, dass eine wesentliche Ursache hierfür die Eindiffusion von Wassermolekülen in das Halbleitermaterial der Solarzellen ist. Um diese Alterung zu hemmen, ist es bekannt, den Randspalt zwischen den beiden laminierten Substraten durch ein als Diffusionsbarriere dienendes Dichtband wasser- und dampfdicht zu versiegeln. Zudem werden die Anschlussdosen beispielsweise mittels eines Heißschmelzklebers am Substrat befestigt, so dass das Innere hermetisch versiegelt ist.

Die internationale Patentanmeldung WO 2009/129405 A2, sowie die Patentschrift DE 103 34 935 B3 beschreiben eine Anschlussbox für ein Solarmodul, bei der Kontaktflecken durch eine Aussparung einer Bodenplatte mit den Endstücken von Folienleitern elektrisch verbunden werden können. Die Endstücke der Folienleiter können durch ein Kontaktloch kontaktiert werden, wobei die Bodenplatte der Anschlussbox das Kontaktloch nicht verschließt. Dies ist auch nicht möglich, da die Kontaktflecken ansonsten nicht mehr die Folienleiter kontaktieren können.

Demgegenüber besteht die Aufgabe der vorliegenden Erfindung darin, herkömmliche Solarmodule in vorteilhafter Weise weiterzubilden, wobei insbesondere eine automatisierte Befestigung und elektrischer Anschluss der Anschlussdosen ermöglicht sein soll. Zudem soll zuverlässig und sicher vermieden werden, dass Wasser oder Dampf an den Anschlussdosen in die Solarzellen eindringt.

Diese und weitere Aufgaben werden nach dem Vorschlag der Erfindung durch ein Solarmodul bzw. Solarmodulanordnung sowie ein Verfahren zu dessen Herstellung mit den Merkmalen der nebengeordneten Patentansprüche gelöst. Vorteilhafte Ausgestaltungen der Erfindung sind durch die Merkmale der Unteransprüche angegeben.

Erfindungsgemäß ist ein Solarmodul mit einem laminierten Verbund aus zwei Substraten gezeigt. Zwischen den Substraten befindet sich ein Schichtenaufbau, der über eine Frontelektrodenschicht, eine Rückelektrodenschicht und eine zwischen den beiden Elektrodenschichten befindliche Halbleiterschicht zur Formung einer Mehrzahl seriell verschalteter Solarzellen verfügt. Bei dem Solarmodul handelt es sich vorzugsweise um ein Dünnschichtsolarmodul mit in integrierter Form verschalteten Dünnschichtsolarzellen. Insbesondere besteht die Halbleiterschicht aus einer Chalkopyrit-Verbindung, bei der es sich beispielsweise um einen I-III-VI-Halbleiter aus der Gruppe Kupfer-Indium/Gallium-Dischwefel/Diselenid (Cu(InGa)(SSE)₂), beispielsweise Kupfer-Indium-Diselenid (CuInSe₂ bzw. CIS) oder verwandte Verbindungen, handeln kann. Die beiden Substrate können beispielsweise anorganisches Glas, Polymere oder Metalllegierungen enthalten und können in Abhängigkeit von Schichtdicke und Materialeigenschaften als starre Platten oder biegsame Folien ausgestaltet sein.

Das Solarmodul weist zwei Spannungsanschlüsse gegensätzlicher Polarität auf, an denen es elektrisch kontaktiert werden kann. Zu diesem Zweck umfasst das Solarmodul zwei Kontaktelemente, die jeweils mit der Front- und/oder Rückelektrodenschicht elektrisch leitend verbunden sind. Vorzugsweise sind die beiden Kontaktelemente jeweils nur mit der Rückelektrodenschicht elektrisch leitend verbunden.

Vorzugsweise ist jedes der beiden Kontaktelemente über einen streifen- bzw. bandförmigen Sammelleiter (Bus Bar) mit der Front- und/oder Rückelektrodenschicht elektrisch leitend verbunden. Somit ist jedes Kontaktelement durch einen Sammelleiter mit Front- und/oder Rückelektrodenschicht elektrisch leitend verbunden, wobei das Kontaktelement vom Sammelleiter verschieden ist. Insbesondere ist das Kontaktelement nicht als Teil oder Abschnitt, insbesondere Endabschnitt, des Sammelleiters ausgebildet.

Die beiden Sammelleiter sind beispielsweise als band- bzw. streifenförmige (Metall-)Folienleiter ausgebildet und bestehen beispielsweise aus Aluminium oder verzinntem Kupfer, wobei aber auch andere elektrisch leitende Materialien verwendet werden können, die sich zu Folien verarbeiten lassen. Beispiele hierfür sind Aluminium, Gold, Silber oder Zinn und Legierungen hiervon. Die Sammelleiter können beispielsweise eine Dicke im Bereich von 0,03 mm bis 0,3 mm und eine Breite im Bereich von 2 mm bis 16 mm haben.

Eine elektrisch leitende Verbindung zwischen den Sammelleitern und der jeweiligen Elektrodenschicht erfolgt beispielsweise durch Schweißen, Bonden, Löten, Klemmen oder Kleben mittels eines elektrisch leitfähigen Klebers. Vorzugsweise sind die beiden Sammelleiter jeweils auf die Rückelektrodenschicht aufgebracht und mit der Rückelektrodenschicht elektrisch leitend verbunden.

Die beiden Kontaktelemente sind in wenigstens einem Kontaktloch (Durchbrechung) wenigstens eines Substrats angeordnet, wobei die beiden Kontaktelemente in einem selben Kontaktloch oder jeweils in einem separaten Kontaktloch angeordnet sein können. Für den Fall, dass zwei Kontaktlöcher vorgesehen sind, können die beiden Kontaktlöcher in einem selben Substrat oder in verschiedenen Substraten ausgebildet sein. Die beiden Kontaktelemente befinden sich wenigstens abschnittsweise, insbesondere vollständig, innerhalb eines Hohlraums, der von dem wenigstens einen Kontaktloch gebildet bzw. umgrenzt wird.

Wesentlich hierbei ist, dass das wenigstens eine Kontaktloch so ausgebildet ist, dass es eine elektrische Verbindung zwischen den Kontaktelementen und der Front- und/oder Rückelektrodenschicht ermöglicht. Für den Fall, dass zwei Sammelleiter vorgesehen sind, wird durch das wenigstens eine Kontaktloch ein Zugang zu den beiden Sammelleitern geschaffen. Vorzugsweise umfasst das Solarmodul zwei Kontaktlöcher, die jeweils Zugang zu einem der beiden Sammelleiter schaffen. Jedes Kontaktelement befindet sich wenigstens abschnittsweise, insbesondere vollständig, innerhalb eines Hohlraums, der von dem einen Kontaktloch gebildet bwz. umgrenzt wird.

Das Solarmodul umfasst weiterhin wenigstens ein Deckelement, das das wenigstens eine Kontaktloch verschließt und zu diesem Zweck an dem das Kontaktloch formenden Substrat befestigt ist. Das Deckelement überdeckt das Kontaktloch vollständig. Beispielsweise umfasst das Solarmodul zwei Deckelemente, die jeweils ein separates Kontaktloch vollständig überdecken bzw. verschließen und am Substrat befestigt sind. Das Deckelement ist beispielsweise in Form einer Platte ausgebildet. Vorzugsweise ist das Deckelement am Substrat so befestigt, dass das Kontaktloch durch das Deckelement gas- und wasserdicht verschlossen ist.

Das wenigstens eine Deckelement verfügt über zwei Kontaktstücke, die jeweils mit einem der beiden Kontaktelemente elektrisch leitend verbunden sind. Hierbei kann das wenigstens eine Deckelement ein elektrisch leitendes Material enthalten, wobei das Deckelement mit den beiden Kontaktelementen elektrisch leitend so verbunden ist, dass die beiden Kontaktstücke durch das Deckelement jeweils mit einem der beiden Kontaktelemente elektrisch leitend verbunden sind.

Vorzugsweise sind zwei Deckelemente vorgesehen, die jeweils mit einem (zugehörigen) Kontaktstück versehen sind, das mit einem der beiden Kontaktelemente elektrisch leitend verbunden ist. Bei dieser Ausgestaltung des Solarmoduls können die Deckelemente jeweils wenigstens teilweise, insbesondere vollständig, aus einem elektrisch leitenden Material bestehen oder ein solches elektrisch leitendes Material enthalten, wobei die Deckelemente jeweils mit einem (zugehörigen) Kontaktelement elektrisch leitend so verbunden ist, dass das Kontaktstuck durch das Deckelement mit dem Kontaktelement elektrisch leitend verbunden ist. Beispielsweise können das Deckelement und das Kontaktstück aus einem elektrisch leitenden Material bestehen, wobei das Kontaktstück am Deckelement befestigt ist. Insbesondere können Deckelement und Kontaktstück einteilig bzw. einstückig ausgebildet sein. Ferner umfasst das Solarmodul wenigstens eine Anschlussdose, welche das wenigstens eine Deckelement umgreifend an dem mit dem wenigstens einen Kontaktloch versehenen Substrat befestigt ist und zwei Kontaktgegenstücke aufweist, die jeweils mit einem der beiden Kontaktstücke in Form einer Steckverbindung elektrisch leitend verbunden sind. Beispielsweise umfasst das Solarmodul zwei Deckelemente und zwei Anschlussdosen, wobei die beiden Anschlussdosen jeweils ein separates Deckelement umgreifend am Substrat befestigt sind und jeweils ein Kontaktgegenstück aufweisen, das mit einem der beiden Kontaktstücke in Form einer Steckverbindung elektrisch leitend verbunden ist. Wesentlich hierbei ist, dass die beiden Kontaktgegenstücke so ausgebildet sind, dass sie bei Befestigung der wenigstens einen Anschlussdose an dem mit dem wenigstens einen Kontaktloch versehenen Substrat selbsttätig in elektrischen Kontakt mit dem zugehörigen Kontaktstück gelangen. Das wenigstens eine Deckelement ist nicht Teil der wenigstens einen Anschlussdose, d.h. Anschlussdose(n) und Deckelement(e) sind voneinander verschieden.

Die wenigstens eine Anschlussdose kann als Basis für einen Anschlussstecker oder eine Anschlussleitung dienen. Außerdem kann es weitere Funktionselemente wie Dioden oder eine Steuerungselektrik aufnehmen. Die wenigstens eine Anschlussdose wird beispielsweise aus einem elektrisch isolierenden Werkstoff hergestellt, wobei sich für eine industrielle Fertigung thermoplastische Kunststoffe und Elastomere anbieten, die im Spritzgussverfahren verarbeitet werden. Als thermoplastische Kunststoffe und Elastomere werden beispielsweise Polyamid, Polyoxymethylen, Polybutylenterephthalat oder Ethylen-Propylen-Dien-Kautschuk verwendet. Alternativ können auch Vergusswerkstoffe wie Acrylat- oder Epoxidharzsysteme zur Herstellung der wenigstens einen Anschlussdose verwendet werden. Denkbar ist jedoch auch, die wenigstens eine Anschlussdose aus Metall oder einem anderen elektrisch leitenden Werkstoff mit elektrisch isolierenden Einsätzen herzustellen.

Die beiden Spannungsanschlüsse des Solarmoduls umfassen somit jeweils ein mit der Front- und/oder Rückelektrodenschicht elektrisch leitend verbundenes Kontaktelement, gegebenenfalls einen die Front- und/oder Rückelektrodenschicht kontaktierenden Sammelleiter, ein mit dem Kontaktelement elektrisch leitend verbundenes Kontaktstück sowie ein damit elektrisch leitend verbundenes Kontaktgegenstück. An das Kontaktgegenstück ist in der Regel ein Anschlussleiter bzw. Anschlussstecker der Anschlussdose elektrisch angeschlossen.

Das erfindungsgemäße Solarmodul ermöglicht in vorteilhafter Weise eine einfache und kostengünstige automatisierte Montage der wenigstens einen Anschlussdose am Substrat, sowie deren elektrische Verbindung mit der Front- und/oder Rückelektrodenschicht zum Bereitstellen der beiden Spannungsanschlüsse des Solarmoduls. Die Steckverbindung zwischen Kontaktstück und Kontaktgegenstück kann grundsätzlich in beliebiger Weise ausgestaltet sein, solange eine elektrische Verbindung durch Aufstecken der Anschlussdose ermöglicht ist. Vorzugsweise sind zu diesem Zweck die Kontaktstücke jeweils als Kontaktstift und die Kontaktgegenstücke jeweils als Federklemmelement zum Klemmen des Kontaktstifts ausgebildet.

Eine Befestigung der wenigstens einen Anschlussdose an dem mit dem wenigstens einen Kontaktloch versehenen Substrat auf der Rück- oder Vorderseite des Solarmoduls kann beispielsweise durch Kleben erfolgen, was den Vorteil hat, dass durch die Verklebung das Innere der Anschlussdose gegen Gase, Wasser oder Feuchtigkeit hermetisch abgedichtet werden kann. Insbesondere sind die elektrischen Kontaktstellen im Innern der Anschlussdose dadurch vor Korrosion geschützt. Für eine Verklebung kann beispielsweise ein Klebestrang oder Klebeband mit einem Kleber auf Acryl-, Polyurethan- oder Polyisobutylenbasis vorgesehen sein. Eine solche Verklebung mit dem Substrat kann in einfacher Weise automatisiert erfolgen. Vorzugsweise wird die wenigstens eine Anschlussdose auf die Modulrückseite geklebt.

Bei einer vorteilhaften Ausgestaltung des erfindungsgemäßen Solarmoduls ist die wenigstens eine Anschlussdose durch die beiden elektrischen Steckverbindungen zwischen den Kontaktstücken und Kontaktgegenstücken an dem mit dem wenigstens einen Kontaktloch versehenen Substrat befestigt. Hierbei kann die Befestigung der wenigstens einen Anschlussdose durch die elektrischen Steckverbindungen zusätzlich zu deren separaten Befestigung am Substrat, beispielsweise durch Verklebung erfolgen, so dass der feste Halt der Anschlussdose am Substrat verbessert werden kann. Alternativ ist jedoch auch denkbar, dass die wenigstens eine Anschlussdose ausschließlich durch die beiden elektrischen Steckverbindungen am Substrat befestigt ist, wobei auf eine separate Befestigung der Anschlussdose beispielsweise durch Verklebung verzichtet wird. Die Montage und der elektrische Anschluss der wenigstens einen Anschlussdose kann somit in besonders einfacher Weise durch bloßes Aufstecken der Kontaktgegenstücke auf die Kontaktstücke erfolgen. Beispielsweise sind zwei Anschlussdosen vorgesehen, die jeweils ausschließlich durch Aufstecken eines Kontaktgegenstücks auf ein Kontaktstück am Substrat befestigt werden können.

Von Vorteil kann es sein, wenn die elektrischen Steckverbindungen zwischen Kontaktstücken und Kontaktgegenstücken jeweils ein Rastorgan aufweisen, so dass die Befestigung der wenigstens einen Anschlussdose einrastend erfolgen kann. Sind die Kontaktstücke jeweils als Kontaktstift und die Kontaktgegenstücke jeweils als Federklemmelement zum Klemmen des Kontaktstifts ausgebildet, kann ein solches Rastorgan besonders einfach realisiert werden, beispielsweise indem eine Komponente der elektrischen Steckverbindung (Kontaktstück oder Kontaktgegenstück) mit zumindest einem Vorsprung versehen ist, der zur verrastenden Befestigung der Anschlussdose in eine entsprechende Vertiefung in der anderen Komponente (Kontaktgegenstück oder Kontaktstück) der elektrischen Steckverbindung greifen kann.

Im erfindungsgemäßen Solarmodul kann die wenigstens eine Anschlussdose durch eine Klebverbindung an dem mit dem wenigstens einen Kontaktloch versehenen Substrat befestigt sein, wobei das Innere der Anschlussdose wasser- bzw. dampfdicht abgeschirmt werden kann. Da die wenigstens eine Anschlussdose das wenigstens eine Deckelement umgreift, kann durch diese Maßnahme gleichermaßen das wenigstens eine Kontaktloch wasser- bzw. dampfdicht abgeschirmt werden. Eine weitere Verbesserung der Wasser- bzw. Dampfdichtigkeit kann dadurch erreicht werden, dass in das wenigstens eine Kontaktloch eine die Solarzellen zur äußeren Umgebung hin wasser- und dampfdicht versiegelnde Dichtmasse eingebracht ist. Bei dem Dichtmasse kann es sich beispielsweise um einen Kleber auf Acryl-, Polyurethan- oder Polyisobutylenbasis handeln. Zudem kann die Dichtmasse dazu dienen, das jeweilige Kontaktelement im Kontaktloch zu fixieren, um die automatisierte Montage weiter zu verbessern.

Im erfindungsgemäßen Solarmodul ist das wenigstens eine Deckelement am zugehörigen Substrat befestigt. Vorzugsweise erfolgt eine Befestigung durch eine stoffschlüssige Verbindung, insbesondere durch einen Klebestrang oder ein Klebeband mit einem Kleber auf Acryl-, Polyurethan- oder Polyisobutylenbasis. Vorzugsweise erfolgt eine Verbindung zwischen Deckelement und Substrat durch Ultraschallschweißen. In der Serienfertigung ist somit eine automatisierte Montage des wenigstens einen Deckelements am Substrat in einfacher Weise kostengünstig ermöglicht. Im Hinblick auf die Automatisierung ist es von Vorteil, wenn die beiden Kontaktstücke jeweils so ausgebildet sind, dass sie beim Befestigen des wenigstens einen Deckelements am Substrat selbsttätig in elektrischen Kontakt mit den Kontaktelementen gelangen. Die Befestigung des wenigstens einen Deckelements am Substrat ist vorzugsweise so ausgebildet, dass das wenigstens eine Kontaktloch gas- und wasserdicht verschlossen ist.

Von Vorteil kann es sein, wenn die Kontaktstücke jeweils durch eine (zerstörungsfrei) lösbare bzw. abnehmbare Verbindung, beispielsweise eine Schraubverbindung, mit dem wenigstens einen Deckelement verbunden sind. Die Kontaktstücke können somit gezielt im Hinblick auf die jeweilige Anwendung angepasst werden, wobei das (übrige) Deckelement als Gleichteil gefertigt werden kann. Zudem kann das Kontaktstück aus einem vom übrigen Deckelement verschiedenen Material gefertigt werden.

Die Erfindung erstreckt sich auch auf ein Verfahren zur automatisierten Herstellung eines wie oben beschriebenen Solarmoduls, insbesondere Dünnschichtsolarmoduls, mit den folgenden Schritten:
- Bereitstellen eines laminierten Verbunds aus zwei Substraten, zwischen denen sich ein Schichtenaufbau befindet, der eine Frontelektrodenschicht, eine Rückelektrodenschicht und eine dazwischen liegende Halbleiterschicht zur Formung einer Mehrzahl seriell verschalteter Solarzellen aufweist,
- Ausbilden wenigstens eines Kontaktlochs in wenigstens einem Substrat;
- Anordnen zweier Kontaktelemente in dem wenigstens einen Kontaktloch und elektrisch leitendes Verbinden mit der Front- und/oder Rückelektrodenschicht;
- Befestigen wenigstens eines Deckelements am Substrat, welches das wenigstens eine Kontaktloch insbesondere gas- und wasserdicht (vollständig) überdeckt, wobei das wenigstens eine Deckelement zwei Kontaktstücke aufweist, welche jeweils mit einem der beiden Kontaktelemente elektrisch leitend verbunden werden;
- Befestigen wenigstens einer, das wenigstens eine Deckelement umgreifenden Anschlussdose an dem mit dem wenigstens einen Kontaktloch versehenen Substrat, wobei die wenigstens eine Anschlussdose zwei Kontaktgegenstücke aufweist, die jeweils mit einem der beiden Kontaktstücke in eine elektrisch leitende Steckverbindung gebracht werden.

Beispielsweise wird durch das wenigstens eine Deckelement ein elektrischer Kontakt mit den beiden Kontaktelementen hergestellt, derart, dass die beiden Kontaktstücke jeweils mit einem der beiden Kontaktelemente elektrisch leitend verbunden werden. Insbesondere können zwei Deckelemente vorgesehen sein, die jeweils über ein Kontaktstück verfügen, wobei jedes Kontaktstück mit einem (zugehörigen) Kontaktelement elektrisch leitend verbunden wird. Beispielsweise wird das Kontaktstück durch das Deckelement mit dem (zugehörigen) Kontaktelement elektrisch leitend verbunden.

Vorzugsweise werden die Kontaktelemente jeweils durch eine in das Kontaktloch eingebrachte, die Solarzellen zur äußeren Umgebung hin wasser- und dampfdicht versiegelnde Dichtmasse fixiert, wodurch die Kontaktelemente besonders einfach in Stellung gebracht werden können.

Vorzugsweise wird die wenigstens eine Anschlussdose (beispielsweise ausschließlich) durch Aufstecken der Kontaktgegenstücke auf die Kontaktstücke an dem mit dem wenigstens einen Kontaktloch versehenen Substrat befestigt, wodurch eine besonders einfache Montage der Anschlussdose ermöglicht ist.

### Kurze Beschreibung der Zeichnungen

Die Erfindung wird nun anhand von Ausführungsbeispielen näher erläutert, wobei Bezug auf die beigefügten Figuren genommen wird. Es zeigen:
- Fig. 1: eine schematische Schnittdarstellung eines Dünnschichtsolarmoduls;
- Fig. 2: eine weitere schematische Schnittdarstellung des Dünnschichtsolarmoduls von Fig. 1 im Bereich einer Anschlussdose;
- Fig. 3: eine schematische Darstellung einer Variante des Dünnschichtsolarmoduls von Fig. 1;
- Fig. 4: eine schematische Darstellung einer weiteren Variante des Dünnschichtsolarmoduls von Fig. 1.

### Ausführliche Beschreibung der Zeichnungen

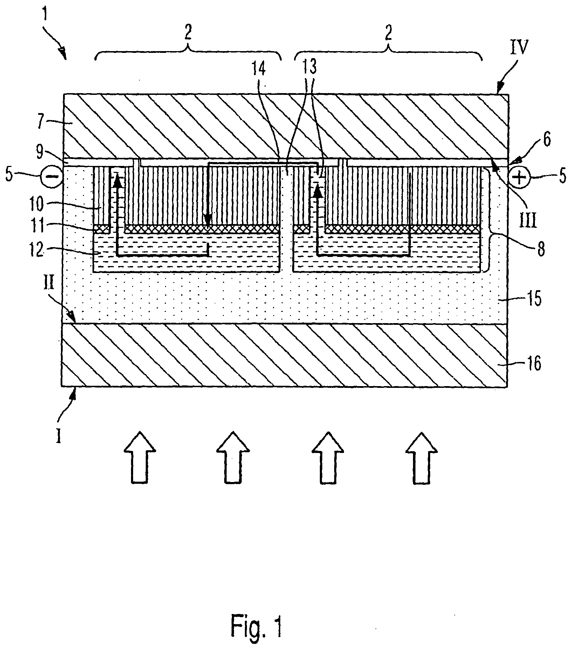

Sei zunächst Figur 1 betrachtet, worin der Aufbau eines insgesamt mit der Bezugszahl 1 bezeichneten Dünnschichtsolarmoduls gemäß vorliegender Erfindung veranschaulicht ist. Demnach umfasst das Dünnschichtsolarmodul 1 eine Mehrzahl in integrierter Form seriell miteinander verschalteter Dünnschichtsolarzellen 2, von denen beispielhaft zwei gezeigt sind. Es versteht sich, dass das Dünnschichtsolarmodul in der Regel über eine Vielzahl (z.B. ca. 100) Dünnschichtsolarzellen 2 verfügt.

Das Dünnschichtsolarmodul 1 basiert hier beispielsweise auf der so genannten Substratkonfiguration. Dabei umfasst es ein elektrisch isolierendes Trägersubstrat 7 mit einem darauf aufgebrachten Schichtenaufbau 6, der auf der lichteintrittseitigen Vorderseite (III) des Trägersubstrats 7 angeordnet ist. Das Trägersubstrat 7 besteht hier beispielsweise aus Glas oder Kunststoff, wobei gleichermaßen andere isolierende Materialien mit genügender Festigkeit, sowie inertem Verhalten gegenüber den durchgeführten Prozessschritten eingesetzt werden können. In Abhängigkeit von der jeweiligen Schichtdicke und den spezifischen Materialeigenschaften kann das Trägersubstrat 7 als starre Platte oder biegsame Folie ausgestaltet sein. Beispielsweise ist das Trägersubstrat 7 in Form einer starren Glasplatte mit einer relativ geringen Lichtdurchlässigkeit ausgebildet.

Der Schichtenaufbau 6 ist beispielsweise durch Aufdampfen auf das Trägersubstrat 7 mittels chemischer Abscheidung (CVD) oder physikalischer Abscheidung (PVD) aus der Gasphase oder Sputtern (magnefeldunterstützte Kathodenzerstäubung) hergestellt. Der Schichtenaufbau 6 umfasst eine auf der Vorderseite (III) des Trägersubstrats 7 angeordnete Rückelektrodenschicht 9. Die Rückelektrodenschicht 9 enthält beispielsweise eine Schicht aus einem lichtundurchlässigen Metall wie Molybdän und wird beispielsweise durch Kathodenzerstäuben auf das Trägersubstrat 7 aufgebracht. Die Rückelektrodenschicht 9 hat beispielsweise eine Schichtdicke von etwa 1 µm. In einer anderen Ausführungsform umfasst die Rückelektrodenschicht 9 einen Schichtstapel unterschiedlicher Einzelschichten. Vorzugsweise enthält der Schichtstapel eine Diffusionsbarriere, um eine Diffusion von beispielsweise Natrium aus dem Trägersubstrat 7 in die auf die Rückelektrodenschicht 9 abgeschiedenen Schichten, welche eine photovoltaisch aktive Absorberschicht 8 bilden, zu verhindern.

Die Absorberschicht 8 enthält eine beispielsweise p-dotierte Halbleiterschicht 10, insbesondere einen p-leitenden Chalkopyrithalbleiter, wie eine Verbindung der Gruppe Kupfer-Indium-Diselenid (CuInSe₂), insbesondere Natrium (Na)-dotiertes Cu(InGa)(SSe)₂. Eine Umsetzung der verschiedenen Metalle der Halbleiterschicht zum Halbleitermaterial erfolgt durch Erwärmen in einem RTP-Ofen (RTP = Rapid Thermal Processing). Die Halbleiterschicht 10 hat beispielsweise eine Schichtdicke von 500 nm bis 5 µm und insbesondere von etwa 2 µm. Auf der Halbleiterschicht 10 ist eine Pufferschicht 11 abgeschieden, die hier beispielsweise eine Einzellage Cadmiumsulfid (CdS) und eine Einzellage intrinsisches Zinkoxid (i-ZnO) enthält. Auf die Pufferschicht 11 ist eine Frontelektrodenschicht 12 aufgebracht, beispielsweise durch Aufdampfen. Die Frontelektrodenschicht 12 ist für Strahlung im für die Halbleiterschicht 11 empfindlichen Spektralbereich transparent ("Fensterschicht"), um eine nur geringe Schwächung des einstrahlenden Sonnenlichts zu gewährleisten. Die transparente Frontelektrodenschicht 12 kann verallgemeinernd als TCO-Schicht (TCO = Transparent Conductive Electrode) bezeichnet werden und basiert auf einem dotierten Metalloxid, beispielsweise n-leitendes, Aluminium-dotiertes Zinkoxid (AZO). Durch die Frontelektrodenschicht 12, die Pufferschicht 11 und die Halbleiterschicht 10 wird ein pn-Heteroübergang gebildet, das heißt eine Abfolge von Schichten vom entgegen gesetzten Leitungstyp. Die Schichtdicke der Frontelektrodenschicht 12 beträgt beispielsweise 300 nm.

Das Schichtsystem ist mit an sich bekannten Verfahren zur Herstellung eines (Dünnschicht-)Solarmoduls 1 in einzelne photovoltaisch aktive Bereiche, d.h. Dünnschichtsolarzellen 2, unterteilt. Die Unterteilung erfolgt durch Einschnitte 13 unter Einsatz einer geeigneten Strukturierungstechnologie wie Laserschreiben und mechanische Bearbeitung, beispielsweise durch Abheben oder Ritzen. Benachbarte Dünnschichtsolarzellen 2 sind über einen Elektrodenbereich 14 der Rückelektrodenschicht 9 seriell miteinander verschaltet.

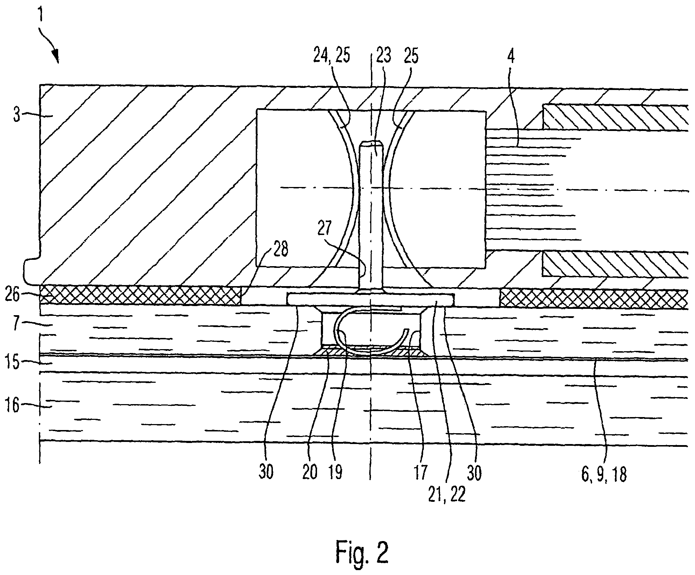

Im hier dargestellten Beispiel werden sowohl der resultierende positive (+) als auch der resultierende negative (-) Spannungsanschluss 5 des Solarmoduls 1 über die Rückelektrodenschicht 9 auf die Rückseite (VI) des Dünnschichtsolarmoduls 1 geführt und dort elektrisch kontaktiert, was in Fig. 2 näher erläutert wird.

Auf der Frontelektrodenschicht 12 ist eine Zwischenschicht 15 aufgebracht, die beispielsweise als thermoplastische Klebeschicht ausgebildet ist und Polyvinylbutyral (PVB) oder Ethylenvinylacetat (EVA) enthält. Die Dicke der Zwischenschicht 15 beträgt beispielsweise 0,76 mm. Zum Schutz vor Umwelteinflüssen ist der Schichtenaufbau aus Trägersubstrat 7, Rückelektrodenschicht 9 und photovoltaisch aktiver Absorberschicht 8 über die Zwischenschicht 15 mit einem als Deckscheibe ausgebildeten Decksubstrat 16 versiegelt, welches mit ihrer Rückseite (II) verklebt ist. Die Zwischenschicht 15 wird durch Erwärmen plastisch verformbar und verbindet beim Abkühlen die beiden Substrate 7, 16 fest miteinander. Das Decksubstrat 16 ist für Sonnenlicht transparent und enthält beispielsweise gehärtetes, extraweißes Glas mit geringem Eisengehalt. Das Decksubstrat 16 weist beispielsweise eine Fläche von 1,6 m x 0,7 m auf. Die Dünnschichtsolarzellen 2 können durch auf der Vorderseite (I) des Decksubstrats 16 einfallendes Licht bestrahlt werden. Insbesondere kann das Decksubstrat 16 auch als KunststoffFolie ausgebildet sein. Allgemein dient das Decksubstrat 16 zur Versiegelung und zum mechanischen Schutz des Schichtenaufbaus 6.

Es ist zweckmäßig wenn der Randbereich zwischen Trägersubstrat 7 und Decksubstrat 16 umlaufend mit einer Randversiegelung als Dampfdiffusionssperre versiegelt wird, vorzugsweise mit einem Kunststoffmaterial, beispielsweise Polyisobutylen, um die korrosionsempfindliche photovoltaisch aktive Absorberschicht 8 vor Luftsauerstoff und Feuchtigkeit zu schützen.

Es sei nun Figur 2 betrachtet, worin eine schematische Schnittdarstellung des Dünnschichtsolarmoduls 1 im Bereich einer Anschlussdose 3 gezeigt ist. Das Dünnschichtsolarmodul 1 verfügt hier beispielsweise über zwei Anschlussdosen 3, jeweils eine für einen Spannungsanschluss 5. Die beiden Anschlussdosen 3 dienen für eine elektrische Kontaktierung des Dünnschichtsolarmoduls 1, beispielsweise um es mit weiteren Dünnschichtsolarmodulen zu einem Modulstrang zu verschalten oder zum Verbinden mit einer elektrischen Last, beispielsweise ein Wechselrichter. Die Anschlussdose 3 verfügt zu diesem Zweck über ein Anschlusskabel 4. Gleichermaßen wäre es auch möglich, die Anschlussdose 3 mit einem Anschlussstecker zu versehen. Die Anschlussdose 3 ist hier beispielsweise als Spritzgussteil aus Kunststoff gefertigt.

Für einen elektrischen Anschluss der Anschlussdose 3 an die Dünnschichtsolarzellen 2 ist in das Trägersubstrat 7 ein Kontaktloch 17 eingearbeitet, durch das Zugang zu einem mit der Rückelektrodenschicht 9 elektrisch leitend verbundenen Sammelleiter 18 geschaffen wird. Der Sammelleiter 18 ermöglicht in vorteilhafter Weise eine Kontaktierung an geeigneter Stelle, beispielsweise am Modulrand.

In das Kontaktloch 17 ist ein vom Sammelleiter 18 verschiedenes, elastisch verformbares Federkontaktelement 19 aus einem elektrisch leitfähigen Material, beispielsweise Federstahl, eingesetzt, welches in Berührungskontakt mit dem Sammelleiter 18 ist. Das Federkontaktelement 19 befindet sich zumindest teilweise innerhalb des Kontaktlochs 17. Eine Fixierung des Federkontaktelements 19 im Kontaktloch 17 erfolgt durch eine Dichtmasse 20, welche im inneren Bereich des Kontaktlochs 17 vollflächig verteilt angeordnet ist. Durch die Dichtmasse 20 wird der Sammelleiter 18 bzw. die Dünnschichtsolarzellen 2 zur äußeren Umgebung hin wasser- und dampfdicht versiegelt, so dass der Eintritt von Wassermolekülen in das Dünnschichtsolarmodul 1 verhindert werden kann. Als Dichtmasse 20 kann grundsätzlich jedes Material gewählt werden, welches geeignet ist, das Federkontaktelement 19 zu fixieren und als Wasser- und Dampfsperre zu dienen. Beispielsweise kann zu diesem Zweck eine Dichtmasse aus Polyisobutylen eingesetzt werden.

Im Bereich des Kontaktlochs 17 ist ein Deckelement 21 auf der Rückseite (IV) des Trägersubstrats 7 befestigt. Das Deckelement 21 umfasst eine plattenförmige Basis 22 und einen daran angeformten Kontaktstift 23, welcher in etwa mittig von der Basis 22 auf der dem Kontaktloch 17 abgewandten Seite senkrecht absteht. Die Basis 22 überdeckt bzw. verschließt das Kontaktloch 17 vollständig, wodurch das Kontaktloch 17 gas- und wasserdicht verschlossen ist. Eine Befestigung des Deckelements 21 auf der Rückseite (IV) des Trägersubstrats 7 erfolgt durch Ultraschallverschweißen der Unterseite der Basis 22 mit dem Trägersubstrat 7, wodurch die ringförmig umlaufende Schweißzone 30 gebildet wird.

Das Deckelement 21 ist einteilig bzw. einstückig aus einem metallischen Material hergestellt, wobei hier beispielsweise Aluminium gewählt wurde, dessen relativ geringe Härte eine Ultraschallverschweißung gut ermöglicht. Zudem kann das Deckelement 21 kostengünstig im Gussverfahren hergestellt werden. Das Deckelement 21 ist von der Anschlussdose 3 verschieden, d.h. ist nicht Teil bzw. Bestandteil oder Abschnitt der Anschlussdose 3.

Bei nicht montiertem Deckelement 21 ragt das Federkontaktelement 19 etwas aus dem Kontaktloch 17 heraus, so dass das Federkontaktelement 19 beim Aufsetzen der Basis 22 des Deckelements 21 auf das Trägersubstrat 7 elastisch verformt wird. Durch die federbelastete Anlage kann ein guter elektrischer Kontakt zwischen dem Deckelement 21 bzw. dem Kontaktstift 23 und dem Federkontaktelement 19 sichergestellt werden. Nach Montage des Deckelements 21 befindet sich das Federkontaktelement 19 vollständig innerhalb des Kontaktlochs 17.

Die Anschlussdose 3 ist im Innern mit einem Federklemmelement 24 versehen, welches aus zwei gekrümmten Metallfedern 25 besteht, welche so angeordnet sind, dass sie den Kontaktstift 23 mit Klemmkraft zwischen sich aufnehmen können. Beim Aufsetzen der Anschlussdose 3 auf die Rückseite (IV) des Trägersubstrats 7 kann der Kontaktstift 23 in einfacher Weise zwischen die beiden Metallfedern 25 gesteckt und dort verklemmt werden. Die Anschlussdose 3 ist zu diesem Zweck auf ihrer dem Trägersubstrat 7 zugewandten Unterseite mit einer die Basis 22 aufnehmenden Aussparung 28 und darin ausgebildeten Öffnung 27 für den Kontaktstift 23 versehen. Vorzugsweise üben die beiden Metallfedern 25 eine solche Klemmkraft aus, dass beim Einstecken des Kontaktstifts 23 in das Federklemmelement 24 eine Oxidschicht auf dem aus Aluminium bestehenden Kontaktstift 23 zumindest teilweise entfernt wird. Denkbar ist jedoch auch, dass der Kontaktstift 23 nicht metallisch blank ist, sondern zum Schutz vor Oxidation und Korrosion mit einer Schutzschicht aus einem Lack oder einer Kunststofffolie überzogen sein kann, die beim Einstecken in das Federklemmelement 24 entfernt wird.

Die Anschlussdose 3 umgreift das Deckelement 21. Das Federklemmelement 24 ist an das Anschlusskabel 4 (oder einen Anschlussstecker) elektrisch angeschlossen, was in Fig. 2 nicht näher dargestellt ist.

Eine Befestigung der Anschlussdose 3 am Trägersubstrat 7 erfolgt auf der Unterseite der Anschlussdose 3 durch eine ringförmig umlaufende Klebschicht 26, welche beispielsweise aus einem Acrylat- oder Polyurethankleber besteht. Neben einer einfachen und dauerhaften Verbindung erfüllen diese Kleber eine Dichtfunktion und schützen die enthaltenen elektrischen Komponenten vor Feuchtigkeit und Korrosion. Bei einer alternativen Ausgestaltung wird die Anschlussdose 3 ausschließlich durch die Klemmwirkung zwischen Kontaktstift 23 und Federklemmelement 24 am Trägersubstrat 7 befestigt, wobei auf eine Klebschicht 26 verzichtet wird.

Die Anschlussdose 3 kann somit in einfacher Weise automatisiert am Trägersubstrat 7 befestigt und an den Sammelleiter 18 elektrisch angeschlossen werden. Zu diesem Zweck wird zunächst (nach Ausbilden des Kontaktlochs 17) das Federkontaktelement 19 in das Kontaktloch 17 eingebracht und dort in elektrischem Kontakt mit dem Sammelleiter 18 durch die Dichtmasse 20 fixiert. Anschließend wird die Basis 22 des Deckelements 21 auf die Rückseite (IV) des Trägersubstrats 7 aufgesetzt und durch Ultraschallschweißen fixiert. Das Deckelement 21 bzw. der Kontaktstift 23 gelangt hierbei selbsttätig in elektrischen Kontakt mit dem Federkontaktelement 19. Im Weiteren wird die Anschlussdose 3 auf die Rückseite (IV) des Trägersubstrats 7 aufgesetzt, wobei der Kontaktstift 23 in das Federklemmelement 24 eingesteckt wird. Durch die zuvor auf die Anschlussdose 3 und/oder die Rückseite (IV) des Trägersubstrats 7 aufgebrachte Klebschicht 26 wird die Anschlussdose 3 am Trägersubstrat 7 befestigt. Alternativ erfolgt die Befestigung nur durch die Steckverbindung zwischen dem Kontaktstift 23 und dem Federklemmelement 24.

Der in Fig. 2 gezeigte Aufbau umfasst drei Vorkehrungen, durch welche die Dünnschichtsolarzellen 2 vor dem Eintritt von Wasser und Dampf geschützt sind. Dies sind die Dichtmasse 20 im Kontaktloch 17, die Schweißzone 30 zwischen Basis 22 und Trägersubstrat 7 und die Klebschicht 26 zwischen der Anschlussdose 3 und dem Trägersubstrat 7. Ein Eintritt von Wassermolekülen kann dadurch zuverlässig und sicher vermieden werden.

Wie bereits ausgeführt, umfasst das Dünnschichtsolarmodul 1 zwei Anschlussdosen 3, die jeweils einem Spannungsanschluss 5 zugeordnet sind. Obgleich dies in Fig. 2 nicht gezeigt ist, wäre es gleichermaßen möglich, dass eine einzige Anschlussdose 3 für die beiden Spannungsanschlüsse 5 vorgesehen ist. In diesem Fall wäre dafür Sorge zu tragen, dass ein elektrischer Überschlag zwischen den beiden Federklemmelementen 24 vermieden wird, was beispielsweise durch eine isolierende Trennwand erreicht werden kann. Ebenso wäre es möglich, dass nur ein einziges Deckelement 21 vorgesehen ist, welches dann in entsprechender Weise über zwei Abschnitte verfügt, die jeweils einem Federkontaktelement 19 zugeordnet sind und gegeneinander elektrisch isoliert sind. Weiterhin wäre es möglich, dass nur ein einziges Kontaktloch 17 vorgesehen ist, in dem die beiden Federkontaktelemente 19 der beiden Spannungsanschlüsse 5 angeordnet sind, die gegeneinander elektrisch isoliert sind.

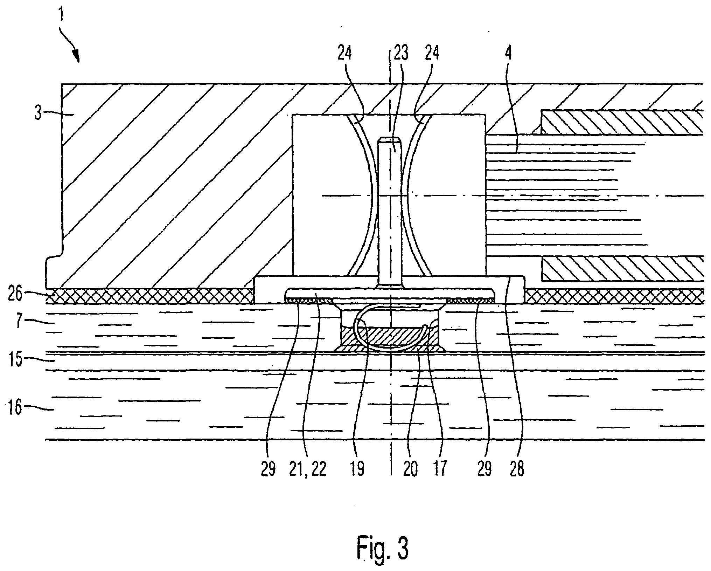

In Fig. 3 ist eine Variante des Dünnschichtsolarmoduls 1 der Figuren 1 und 2 veranschaulicht. Um unnötige Wiederholungen zu vermeiden, werden lediglich die Unterschiede zu diesem Dünnschichtsolarmodul 1 erläutert und ansonsten wird auf die dort gemachten Ausführungen Bezug genommen.

Demnach ist die Basis 22 des Deckelements 21 nicht durch Ultraschallschweißen sondern durch ein Klebmittel 29 am Trägersubstrat 7 befestigt. Das Klebmittel 29 ist beispielsweise als Klebschicht oder doppelseitiges Klebeband mit einem Kleber auf Acryl-, Polyurethan- oder Polyisobutylenbasis ausgebildet.

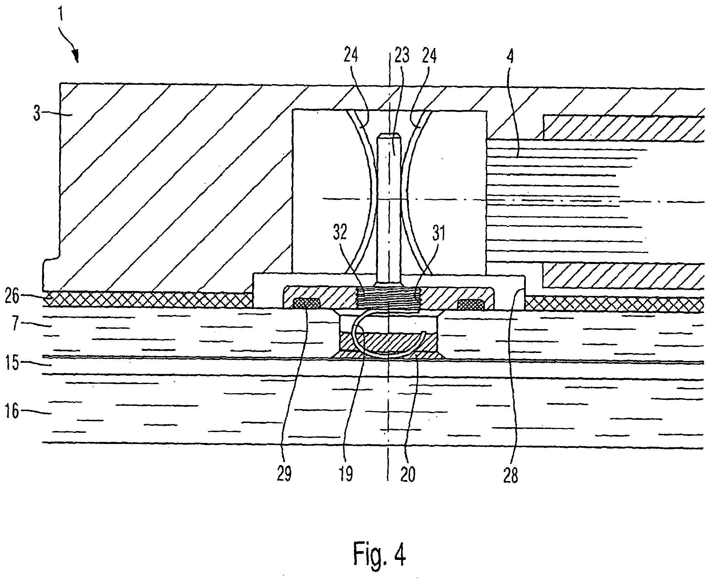

In Fig. 4 ist eine weitere Variante des Dünnschichtsolarmoduls 1 der Figuren 1 und 2 veranschaulicht, wobei wiederum lediglich die Unterschiede zum ersten Ausführungsbeispiel erläutert werden.

Bei dieser Ausgestaltung ist das Deckelement 21 nicht einteilig bzw. einstückig ausgebildet, sondern besteht aus der plattenförmigen Basis 22, die hier mit einer Gewindebohrung 31 versehen, in die der Kontaktstift 23 mittels eines Gewindesockels 32 eingeschraubt ist. Dies erlaubt je nach Anwendung eine gezielte Anpassung des Kontaktstifts 23. Zudem können die Materialien von Basis 22 und Kontaktstift 23 voneinander verschieden sein. Insbesondere kann die Basis 22 auch aus einem elektrisch isolierenden Material bestehen. Die Basis 22 ist durch ein ringförmig umlaufendes Klebmittel 29 (Heißschmelzkleber) auf das Trägersubstrat 7 geklebt. Bei der Befestigung der Basis 22 am Trägersubstrat 7 gelangt der Kontaktstift 23 in direkten elektrischen Kontakt mit dem Federkontaktelement 19.

Die Erfindung stellt ein Solarmodul, insbesondere Dünnschichtsolarmodul, zur Verfügung, das in der industriellen Serienfertigung eine einfache und kostengünstige automatisierte Montage der Anschlussdosen an Kontaktlöchern und deren Anschluss an die Elektrodenschicht(en) der Solarzellen ermöglicht. Die Eindiffusion von Wassermolekülen an den Kontaktlöchern kann zuverlässig und sicher verhindert werden.

### Bezugszeichenliste

- 1: Dünnschichtsolarmodul
- 2: Dünnschichtsolarzelle
- 3: Anschlussdose
- 4: Anschlusskabel
- 5: Spannungsanschluss
- 6: Schichtenaufbau
- 7: Trägersubstrat
- 8: Absorberschicht
- 9: Rückelektrodenschicht
- 10: Halbleiterschicht
- 11: Pufferschicht
- 12: Frontelektrodenschicht
- 13: Einschnitt
- 14: Elektrodenbereich
- 15: Zwischenschicht
- 16: Decksubstrat
- 17: Kontaktloch
- 18: Sammelleiter
- 19: Federkontaktelement
- 20: Dichtmasse
- 21: Deckelement
- 22: Basis
- 23: Kontaktstift
- 24: Federklemmelement
- 25: Metallfeder
- 26: Klebschicht
- 27: Öffnung
- 28: Aussparung
- 29: Klebmittel
- 30: Schweißzone
- 31: Gewindebohrung
- 32: Gewindesockel

## Patentansprüche

1. Solarmodul (1), insbesondere Dünnschichtsolarmodul, welches umfasst:
- einen laminierten Verbund aus zwei Substraten (7, 16), zwischen denen sich ein Schichtenaufbau (6) befindet, der eine Frontelektrodenschicht (12), eine Rückelektrodenschicht (9) und eine zwischen liegende Halbleiterschicht (10) zur Formung einer Mehrzahl seriell verschalteter Solarzellen (2) aufweist,
- zwei Kontaktelemente (19), welche mit der Front- und/oder Rückelektrodenschicht (9, 12) elektrisch leitend verbunden sind, wobei die Kontaktelemente jeweils in wenigstens einem Kontaktloch (17) wenigstens eines Substrats (7, 16) angeordnet sind,
- wenigstens ein Deckelement (21), das an dem mit dem wenigstens einen Kontaktloch (17) versehenen Substrat (7) befestigt ist und das wenigstens eine Kontaktloch (17) verschließt,
- zwei Kontaktstücke (23), die mit dem wenigstens einen Deckelement (21) verbunden sind und jeweils mit einem der beiden Kontaktelemente (19) elektrisch leitend verbunden sind,
- wenigstens eine Anschlussdose (3), welche das wenigstens eine Deckelement (21) umgreifend an dem mit dem wenigstens einen Kontaktloch (17) versehenen Substrat (7) befestigt ist und zwei Kontaktgegenstücke (24) aufweist, die jeweils mit einem der beiden Kontaktstücke (23) in Form einer Steckverbindung elektrisch leitend verbunden sind.

2. Solarmodul (1) nach Anspruch 1, bei welchem die beiden Kontaktelemente (19) jeweils über einen streifenförmigen Sammelleiter (18) mit der Front- und/oder Rückelektrodenschicht (9, 12) elektrisch leitend verbunden sind.

3. Solarmodul (1) nach einem der Ansprüche 1 oder 2, bei welchem die beiden Kontaktelemente (19) jeweils als elastisch verformbares Federkontaktelement ausgebildet sind.

4. Solarmodul (1) nach einem der Ansprüche 1 bis 3, bei welchem die Kontaktstücke (23) jeweils als Kontaktstift und die Kontaktgegenstücke (24) jeweils als Federklemmelement ausgebildet sind.

5. Solarmodul (1) nach einem der Ansprüche 1 bis 4, bei welchem die wenigstens eine Anschlussdose (3) durch die elektrischen Steckverbindungen zwischen Kontaktstücken (23) und Kontaktgegenstücken (24) an dem mit dem wenigstens einen Kontaktloch (17) versehenen Substrat (7) befestigt ist.

6. Solarmodul (1) nach Anspruch 5, bei welchem die elektrischen Steckverbindungen zwischen Kontaktstücken (23) und Kontaktgegenstücken (24) jeweils ein Rastorgan aufweisen.

7. Solarmodul (1) nach einem der Ansprüche 1 bis 6, bei welchem in das wenigstens eine Kontaktloch (17) eine die Solarzellen (2) zur äußeren Umgebung hin wasser- und dampfdicht versiegelnde Dichtmasse (20) eingebracht ist.

8. Solarmodul (1) nach Anspruch 7, bei welchem die Kontaktelemente (19) durch die Dichtmasse (20) in dem wenigstens einen Kontaktloch (17) fixiert sind.

9. Solarmodul (1) nach einem der Ansprüche 1 bis 8, bei welchem das wenigstens eine Deckelement (21) durch eine stoffschlüssige Verbindung an dem mit dem wenigstens einen Kontaktloch (17) versehenen Substrat (7) befestigt ist.

10. Solarmodul nach Anspruch 9, bei welchem die stoffschlüssige Verbindung zwischen Deckelement (21) und Substrat (7) das Kontaktloch (17) umlaufend ausgebildet ist.

11. Solarmodul nach einem der Ansprüche 1 bis 10, bei welchem die Kontaktstücke (23) jeweils so ausgebildet sind, dass sie beim Befestigen des wenigstens einen Deckelements (21) an dem mit dem wenigstens einen Kontaktloch (17) versehenen Substrat (7) selbsttätig in elektrischen Kontakt mit den Kontaktelementen (19) gelangen.

12. Solarmodul (1) nach einem der Ansprüche 1 bis 11, bei welchem die Kontaktstücke (23) jeweils durch eine lösbare Verbindung, beispielsweise eine Schraubverbindung, mit dem wenigstens einen Deckelement (21) verbunden sind.

13. Verfahren zur automatisierten Herstellung eines Solarmoduls (1), insbesondere Dünnschichtsolarmoduls, mit den folgenden Schritten:
- Bereitstellen eines laminierten Verbunds aus zwei Substraten (7, 16), zwischen denen sich ein Schichtenaufbau (6) befindet, der eine Frontelektrodenschicht (12), eine Rückelektrodenschicht (9) und eine zwischen liegende Halbleiterschicht (10) zur Formung einer Mehrzahl seriell verschalteter Solarzellen (2) aufweist,
- Ausbilden wenigstens eines Kontaktlochs (17) in wenigstens einem Substrat (7);
- Anordnen zweier Kontaktelemente (19) in dem wenigstens einen Kontaktloch (17) und elektrisch leitendes Verbinden mit der Front- und/oder Rückelektrodenschicht (9, 12);
- Befestigen wenigstens eines Deckelements (21) am Substrat, welches das wenigstens eine Kontaktloch (17) überdeckt, wobei das wenigstens eine Deckelement (21) zwei Kontaktstücke (23) aufweist, welche jeweils mit einem der beiden Kontaktelemente (19) elektrisch leitend verbunden werden;
- Befestigen wenigstens einer, das wenigstens eine Deckelement (21) umgreifenden Anschlussdose (3) an dem mit dem wenigstens einen Kontaktloch (17) versehenen Substrat (7), wobei die wenigstens eine Anschlussdose (3) zwei Kontaktgegenstücke (24) aufweist, die jeweils mit einem der beiden Kontaktstücke (23) in eine elektrisch leitende Steckverbindung gebracht werden.

14. Verfahren nach Anspruch 13, bei welchem die Kontaktelemente (19) jeweils durch eine in das Kontaktloch (17) eingebrachte, die Solarzellen (2) zur äußeren Umgebung hin wasser- und dampfdicht versiegelnde Dichtmasse (20) fixiert werden.

15. Verfahren nach einem der Ansprüche 13 oder 14, bei welchem die wenigstens eine Anschlussdose (3) durch Aufstecken der Kontaktgegenstücke (24) auf die Kontaktstücke (23) an dem mit dem wenigstens einen Kontaktloch (17) versehenen Substrat (7) befestigt wird.

## Claims

1. Solar module (1), in particular a thin-film solar module, which comprises:
- a laminated composite made up of two substrates (7, 16), between which a layer structure (6) is situated, which has a front electrode layer (12), a rear electrode layer (9), and an intermediate semiconductor layer (10) for forming a plurality of solar cells (2) connected in series,
- two contact elements (19) that are electrically conductively connected to the front and/or rear electrode layer(s) (9, 12), wherein the contact elements are in each case arranged in at least one contact hole (17) of at least one substrate (7, 16),
- at least one covering element (21) that is mounted on the substrate (7) provided with the at least one contact hole (17) and that seals the at least one contact hole (17),
- two contact pieces (23) that are connected to the at least one covering element (21) and are in each case electrically conductively connected to one of the two contact elements (19),
- at least one connection socket (3) that is mounted, encompassing the at least one covering element (21), on the substrate provided with the at least one contact hole and has two mating contact pieces (24) that are in each case electrically conductively connected to one of the two contact pieces (23) in the form of a plug connection.

2. Solar module (1) according to claim 1, wherein the two contact elements (19) are in each case electrically conductively connected via a strip-shaped busbar (18) to the front and/or rear electrode layer (9, 12).

3. Solar module (1) according to one of claims 1 or 2, wherein the two contact elements (19) are in each case implemented as an elastically deformable spring contact element.

4. Solar module (1) according to one of claims 1 through 3, wherein the contact pieces (23) are in each case implemented as a contact pin and the mating contact pieces (24) are in each case implemented as a spring clamping element.

5. Solar module (1) according to one of claims 1 through 4, wherein the at least one connection socket (3) is mounted by the electrical plug connections between contact pieces (23) and mating contact pieces (24) on the substrate (7) provided with the at least one contact hole (17).

6. Solar module (1) according to claim 5, wherein the electrical plug connections between contact pieces (23) and mating contact pieces (24) have in each case a latching member.

7. Solar module (1) according to one of claims 1 through 6, wherein a sealing compound (20) water-tightly and vapor-tightly sealing the solar cells (2) against the external surroundings is introduced into the at least one contact hole (17).

8. Solar module (1) according to claim 7, wherein the contact elements (19) are fixed in the at least one contact hole (17) by the sealing compound (20).

9. Solar module (1) according to one of claims 1 through 8, wherein the at least one covering element (21) is mounted by a substance-to-substance bond on the substrate (7) provided with the at least one contact hole (17).

10. Solar module according to claim 9, wherein the substance-to-substance bond between the covering element (21) and the substrate (7) is implemented all around the contact hole (17).

11. Solar module according to one of claims 1 through 10, wherein the contact pieces (23) are implemented in each case such that they automatically make electrical contact with the contact elements (19) at the time of the mounting of the at least one covering element (21) on the substrate (7) provided with the at least one contact hole (17).

12. Solar module (1) according to one of claims 1 through 11, wherein the contact pieces (23) are in each case connected to the at least one covering element (21) by a detachable connection, for example, a screw connection.

13. Method for automated production of a solar module (1), in particular a thin-film solar module, with the following steps:
- Preparation of a laminated composite made up of two substrates (7, 16), between which a layer structure (6) is situated, which has a front electrode layer (12), a rear electrode layer (9), and an intermediate semiconductor layer (10) for forming a plurality of solar cells (2) connected in series,
- Formation of at least one contact hole (17) in at least one substrate (7);
- Arrangement of two contact elements (19) in the at least one contact hole (17) and electrically conductive connection to the front and/or rear electrode layer (9, 12);
- Mounting of at least one covering element (21) on the substrate, which covers the at least one contact hole (17), wherein the at least one covering element (21) has two contact pieces (23) that are in each case electrically connected to one of the two contact elements (19);
- Mounting of at least one connection socket (3) encompassing the at least one covering element (21) on the substrate (7) provided with the at least one contact hole (17), wherein the at least one connection socket (3) has two mating contact pieces (24), which are brought in each case into an electrically conductive plug connection with one of the two contact pieces (23).

14. Method according to claim 13, wherein the contact elements (19) are fixed in each case by a sealing compound (20) introduced into the contact hole (17) sealing the solar cells (2) water-tightly and vapor-tightly against the external surroundings.

15. Method according to one of claims 13 or 14, wherein the at least one connection socket (3) is mounted by plugging in the mating contact pieces (24) on the contact pieces (23) on the substrate (7) provided with the at least one contact hole (17).

## Revendications

1. Module solaire 1 (1), en particulier module solaire à couche mince, qui comprend
- un composite stratifié de deux substrats (7, 16) entre lesquels se trouve une structure stratifiée (6) qui présente une couche d'électrodes avant (12), une couche d'électrodes arrière (9) et une couche semi-conductrice interposée (10) pour former une pluralité de cellules solaires (2) interconnectées en série,
- deux éléments de contact (19), qui sont reliés électriquement conducteurs avec la couche d'électrodes avant et/ou arrière (9, 12), où les éléments de contact sont disposés chacun dans au moins un orifice de contact (17) d'au moins un substrat (7, 16),
- au moins un élément de recouvrement (21) qui est fixé audit substrat (7) muni d'au moins un orifice de contact (17), et qui ferme ledit au moins un orifice de contact (17),
- deux pièces de contact (23) qui sont reliées audit au moins un élément de recouvrement (21) et qui sont chacune reliées de manière électriquement conductrice à l'un des deux éléments de contact (19),
- au moins un boîtier de connexion (3) qui est fixée sur le substrat (7) muni dudit au moins un orifice de contact (17) de manière à entourer ledit au moins un élément de recouvrement (21) et qui présente deux pièces de contact de contrepartie (24), qui sont reliées de manière électriquement conductrice respectivement à l'une des deux pièces de contact (23) sous la forme d'une connexion enfichable.

2. Module solaire (1) selon la revendication 1, où les deux éléments de contact (19) sont reliés de manière électriquement conductrice respectivement à la couche d'électrodes avant et/ou arrière (9, 12) par un conducteur collectif (18) en forme de bande.

3. Module solaire 1 (1) selon l'une des revendications 1 ou 2, où les deux éléments de contact (19) sont conçus respectivement comme un élément de contact à ressort élastiquement déformable.

4. Module solaire (1) selon l'une des revendications 1 à 3, où les pièces de contact (23) sont conçues respectivement comme broche de contact et les pièces de contact de contrepartie (24) sont conçues respectivement comme élément de serrage à ressort.

5. Module solaire 1 (1) selon l'une des revendications 1 à 4, où ledit au moins un boîtier de connexion (3) est fixé audit substrat (7) pourvu dudit au moins un orifice de contact (17) par le biais des connexions électriques enfichables entre pièces de contact (23) et pièces de contact de contrepartie correspondantes (24).

6. Module solaire (1) selon la revendication 5, où les connexions électriques par enfichage entre les pièces de contact (23) et les pièces de contact de contrepartie (24) présentent chacune un élément d'encliquetage.

7. Module solaire (1) selon l'une des revendications 1 à 6, où une masse d'étanchéité (20) qui scelle les cellules solaires (2) à l'eau et à la vapeur (20) par rapport à l'environnement extérieur) est appliqué dans ledit au moins un orifice de contact (17).

8. Module solaire (1) selon la revendication 7, où les éléments de contact (19) sont fixés par la masse d'étanchéité (20) dans ledit au moins un orifice de contact (17).

9. Module solaire (1) selon l'une des revendications 1 à 8, où ledit au moins un élément de recouvrement (21) est fixé au substrat (7) muni dudit au moins un orifice de contact (17) au moyen d'une liaison de matière à matière.

10. Module solaire selon la revendication 9, où la liaison de matière à matière entre l'élément de recouvrement (21) et le substrat (7) est réalisée de manière à entourer l'orifice de contact (17).

11. Module solaire selon l'une des revendications 1 à 10, où les pièces de contact (23) sont conçues respectivement de telle sorte qu'elles entrent automatiquement en contact électrique avec les éléments de contact (19) lorsque ledit au moins un élément de recouvrement (21) est fixé sur ledit substrat (7) pourvu d'au moins un orifice de contact (17).

12. Module solaire (1) selon l'une des revendications 1 à 11, où les pièces de contact (23) sont respectivement reliées audit au moins un élément de recouvrement (21) par une connexion amovible, par exemple un raccord vissé.

13. Module de fabrication automatisée d'un module solaire (1), en particulier d'un module solaire à couche mince, avec les étapes suivantes :
- fourniture d'un composite stratifié de deux substrats (7, 16) entre lesquels se trouve une structure en couches (6) comprenant une couche d'électrodes avant (12), une couche d'électrodes arrière (9) et une couche semi-conductrice intermédiaire (10) pour former une pluralité de cellules solaires (2) reliées en série,
- formation d'au moins un orifice de contact (17) dans au moins un substrat (7);
- agencement de deux éléments de contact (19) dans ledit au moins un orifice de contact (17) et connexion de manière électriquement conductrice avec la couche d'électrodes avant et/ou arrière (9, 12);
- fixation d'au moins un élément de recouvrement (21) sur le substrat, qui recouvre ledit au moins un orifice de contact (17), où ledit au moins un élément de recouvrement (21) présente deux pièces de contact (23) qui sont chacune reliées de manière électriquement conductrice à l'un des deux éléments de contact (19);
- fixation d'au moins un boîtier de connexion (3), qui entoure ledit au moins un élément de recouvrement (21), sur le substrat (7) muni dudit au moins un orifice de contact (17), où ladite au moins un boîtier de connexion (3) présente deux pièces de contact de contrepartie (24) qui sont respectivement mises en connexion par enfichage de manière électriquement conductrice avec l'une des deux pièces de contact (23).

14. Procédé selon la revendication 13, où les éléments de contact (19) sont fixés respectivement par une masse d'étanchéité (20) qui est introduite dans l'orifice de contact (17) et qui scelle les cellules solaires (2) de manière étanche à l'eau et à la vapeur par rapport au milieu extérieur.

15. Procédé selon l'une des revendications 13 ou 14, où ledit au moins un boîtier de connexion (3) est fixé sur le substrat (7) muni dudit au moins un orifice de contact (17) en enfichant les pièces de contact de contrepartie (24) sur les pièces de contact (23).
